# EUROPEAN PATENT SPECIFICATION

(11) **EP 3 367 447 B1**
(45) Date of publication and mention of the grant of the patent: **09.10.2019**
(21) Application number: 17157335.5
(22) Date of filing: 22.02.2017
(51) Int. Cl.: H01L 33/24, H01L 33/08, H01L 33/18

(54) **NANOWIRE DEVICE AND METHOD OF MANUFACTURING THEREOF**
NANODRAHTBAUELEMENT UND DESSEN HERSTELLUNGSMETHODE
DISPOSITIF DE NANOFIL ET SON PROCÉDÉ DE FABRICATION

(43) Date of publication of application: 29.08.2018
(73) Proprietor: Forschungsverbund Berlin e.V., 12489 Berlin (DE)
(72) Inventor: Corfdir, Pierre Michel, 12163 Berlin (DE); Lewis, Ryan B., Hamilton, ON L8L-7P2 (CA); Geelhaar, Lutz, 10825 Berlin (DE)
(74) Representative: v. Bezold & Partner Patentanwälte - PartG mbB

(56) References cited:
- WO-A2-2013/184203
- US-A1- 2008 149 944
- US-A1- 2010 213 579

## Description

The present invention relates to a nanowire device (or: nanowire-based optical device, nanowire light emitting device), e. g. for optical or opto-electronic applications, in particular including at least one bent nanowire on a substrate, and to a method of manufacturing the nanowire device. Applications of the invention are available e. g. in the field of optoelectronics and light emitters. In the present specification, reference is made to the following prior art illustrating the technical background of the invention:
[1] Bakkers, E.P.A.M. et al. in "MRS Bull." 32, 117 (2007);
[2] Kavanagh, K. L. in "Semicond. Sci. Technol." 25, 024006 (2010);
[3] Dimakis, E. et al. in "Nano Lett." 14, 2604 (2014);
[4] Limbach, F. et al. in "Nanotechnology" 23, 465301 (2012)];
[5] Wang, J. et al. in "Science" 293, 1455 (2001);
[6] Zhang, X. et al. in "Nanoscale Res. Lett." 5, 1692 (2010);
[7] Sibirev N. V. et al. in "J. Appl. Phys." 111, 104317 (2012);
[8] Keplinger, M. et al. in "Nucl. Instruments Methods Phys. Res. Sect. B" 268, 316 (2010);
[9] Dietrich, C. P. et al. in "Appl. Phys. Lett." 98, 031105 (2011);
[10] Xu, S. et al. in "Nano Lett." 12, 5802 (2012);
[11] Fu X. et al. in "Adv. Mater." 26, 2572 (2014)];
[12] Fu X. et al. in "ACS Nano" 8, 3412 (2014);
[13] Adams in "IEEE J. Sel. Top. Quantum Electron." 17, 1364 (2011);
[14] Salehzadeh, O. et al. in "J. Appl. Phys." 114, 054301 (2013);
[15] US 2008/149944 A1 (SAMUELSON LARS IVAR [SE] ET AL; publication date: 26 June 2008) discloses LEDs with nanowires grown in preferred directions;
[16] US 2010/213579 A1 (HENRY MICHAEL D [US] ET AL; publication date: 26 August 2010) discloses methods for fabrication of high aspect ratio micropillars and nanopillars.

It is generally known that planar semiconductor heterostructure design is highly constrained by the substrate lattice parameter, generally restricting heterostructure materials to those within a narrow lattice parameter range. This severely limits the range of device wavelengths that can be reached for a given substrate and has been a major obstacle preventing the integration of III-V optoelectronic materials with the Si platform. Nanowires offer a promising way to overcome these restrictions. Due to their small footprint, e. g. group III-V nanowires of high crystal quality can be grown directly on highly lattice mismatched substrates, as shown e.g. with the growth of GaAs nanowires on Si substrates in [1]. Furthermore, heterostructures formed within nanowires can more efficiently relax strain at free surfaces and throughout the nanowire, allowing coherent heterostructures to be realized with higher lattice mismatches than those possible in the planar case (see e. g. [2]).

Semiconductor nanowire-based light emitting devices typically consist of semiconductors deposited in the form of straight perpendicular nanowires on a substrate, with the nanowire's axis pointing along the substrate normal (see e. g. [3] or [4]). In these devices, it is typically desirable that light is emitted in the direction perpendicular to the substrate, i.e. along the nanowire axis. However, the diameter of these nanowires is usually on the order or smaller than the wavelength of the emitted light and light coupling in the direction normal to the substrate is significantly reduced (see [5]). Accordingly, nanowire devices with straight perpendicular nanowires have disadvantages in terms of low light emission efficiency in the direction perpendicular to the substrate.

While the growth of straight tilted nanowires in directions tilted from the substrate normal (see [6]) in principle allows for better absorption and extraction of light propagating normal to the substrate, it poses challenges for the deposition of shells due to shadowing effects [7]. Accordingly, nanowire devices with straight tilted nanowires have limitations in terms of fabricating heterostructures suitable for light emission applications.

As a further design alternative, bent nanowires have been described in [8], which are obtained as a result of inhomogeneous growth of a lattice mismatched shell. The impact of strain and piezoelectric fields on bent nanowires which were dispersed on a substrate and then mechanically bent has been studied in [9] and [10]. In particular, the drift of charge carriers towards the outer side of mechanically bent ZnO nanowires has been investigated by continuous-wave and time-resolved cathodoluminescence experiments in [11] and [12], respectively. Despite of the extended investigations of bent nanowires, the applications thereof are restricted. In particular, practical and efficient light emission applications of bent nanowires have not yet been obtained.

The objective of the invention is to provide an improved nanowire device, e. g. for optical or opto-electronic applications, including at least one nanowire on a substrate, being capable of avoiding disadvantages of conventional nanowire devices. In particular, the objective is to provide the nanowire device being capable of emitting light normal to the substrate with improved efficiency and/or having additional degrees of freedom for setting light emission properties. Furthermore, the objective of the invention is to provide an improved method of manufacturing the nanowire device, being capable of avoiding disadvantages of conventional manufacturing methods.

These objectives are respectively solved by the bent nanowire device and the method of manufacturing thereof, including the features of the independent claims. Preferred embodiments and applications of the invention are defined in the dependent claims.

According to a first general aspect of the invention, a nanowire device is provided, which comprises a substrate and at least one nanowire standing on the substrate. The at least one nanowire generally includes two nanowire regions each comprising a monocrystalline, polycrystalline or amorphous material and extending along the length of the nanowire, which are indicated here as a core region and a bending region. The core region comprises a semiconductor material extending over the whole length of the nanowire. The bending region (or: bending layer) comprises a different material or material composition, like e. g. an insulator material, a semiconductor material, a metal, and/or a polymer, and it is adapted for inducing strain in the nanowire, in particular at an interface of the core region, such that the at least one nanowire is bent in a bending direction deviating from the normal (orthogonal) direction of the substrate. The bending region extends over the whole length of the nanowire or a section thereof. The strain inducing effect of the bending region is obtained from providing the core and bending regions with materials, which are different from each other, preferably in terms of lattice constants, obtained e. g. by different compositions of composite semiconductors, and/or thermal expansion coefficients. The bending region can be provided on one side of the core region only. Alternatively, the bending region can be provided on multiple or even all sides of the core region, if the bending region has different thicknesses on different sides of the nanowire (i. e. if the bending region has an asymmetric cross-section). Accordingly, the cross-section of the at least one nanowire is asymmetric in thicknesses and/or compositions. With a preferred example, for a nanowire with a hexagonal cross-section, the bending region would be provided on at least two sides of the hexagon. The bending region can be provided directly on the core region or with an intermediate passivation region (or: passivation layer) therebetween.

According to the invention, the at least one nanowire includes an active region being located in a tensely strained portion of the at least one nanowire. The material of the tensely strained portion has a tensile strain compared to an average strain in the at least one nanowire. The average strain in the nanowire depends on the effect of the bending region, and it can be compressively or tensely strained compared with a non-strained (relaxed) nanowire. In other words, the term "tensely strained portion" refers to a portion of the nanowire, where the nanowire has a tensile strain compared with a non-strained (relaxed) nanowire or a compressive strain which is less compressive compared with the remaining nanowire.

The active region comprises at least one semiconductor arranged as a single element being positioned in the nanowire or extending along at least a part of the length of the nanowire, or as multiple elements being distributed along the length of the nanowire. According to the invention, the core region and the active region provide a heterostructure being configured for light emission by carrier recombination. Accordingly, the nanowire device is a nanowire-based light emitting device. Due to the location of the active region in the tensely strained portion of the at least one nanowire, carrier transport towards the active region is enhanced compared with the transport in in other radial directions of the nanowire. The efficiency of carrier collection within the nanowire and thus the efficiency of carrier recombination and light emission are improved.

Advantageously, the light emitting properties of the nanowire device are determined by strain engineering in the nanowire(s). Strain engineering has been used in planar semiconductor heterostructures already to improve the efficiency of optoelectronic devices [13]. Core-shell nanowire heterostructures offer more flexibility for strain engineering, accommodating larger lattice mismatches by relaxing strain at the free surfaces and partitioning strain between the non-rigid core and the shell(s) [14].

According to a second general aspect of the invention, a method of manufacturing the nanowire device according to the above first general aspect of the invention is provided, wherein the at least one nanowire including the active region is created on the substrate and the bending region is deposited, such that the at least one nanowire is bent in the bending direction and the active region is located in the tensely strained portion of the at least one nanowire.

The invention has the following particular advantages. Firstly, contrary to conventional nanowire devices with straight perpendicular nanowires and as a result of the bent shape of the nanowire, an enhanced light coupling efficiency for semiconductor nanowire-based light emitting devices in the direction normal to the substrate is achieved. Secondly, spatially-varying strain in the nanowire is used to achieve efficient trapping of carriers in an optoelectronic active region. Contrary to conventional nanowire devices with bent nanowires, the inventive nanowire device includes a heterostructure which provides an enhanced carrier recombination. Simultaneously, the bandgap in the active region and hence the emission wavelength of the active region is controlled, in particular towards longer wavelengths than that accessible in the homogeneously-strained case (e.g. the telecommunication wavelength windows at 1.3 and 1.55 µm or the green and yellow spectral ranges in the visible). Furthermore, contrary to conventional nanowire devices with tilted straight nanowires, the manufacturing of the inventive nanowire device is essentially facilitated as the curved shape of the nanowire is inherently obtained by the material combination of the core and bending regions.

The bent nanowire is characterized by a bending arc defining in particular the radius of curvature of the nanowire. The side of the nanowire facing away from the substrate is indicated here as the "upper curvature side" or "outer side" of the at least one nanowire, whereas the opposite side of the nanowire facing to the substrate is indicated here as the "lower curvature side" or "inner side" of the at least one nanowire. The value of the axial strain in the bent nanowire increases from the inside toward the outer part of the bending arc, i. e. from the inner side to the outer side of the nanowire.

With further details, this variation in the strain state has the following advantageous effects. Firstly, relative to a symmetric unbent structure, material near the inside of the bending arc is compressively strained while material near the outside is tensely strained (or has less compressive strain compared with the inner material). This relative tensile strain redshifts the bandgap of material near the outside of the bending arc, making it possible to access emission wavelengths longer than for unbent nanowires. Furthermore, the bandgap variation along the bending arc produces a quasi-electric field, which directs electrons and holes towards the outer part of the bending arc. By placing the active region near or on the outer side of the bent nanowire, the carriers from the core region are efficiently captured by the active region as a result of the drift produced by the bandgap variation.

A consequence of the quasi one-dimensional nanowire geometry is that the coupling of light into and out of the nanowires for light propagating in the axial direction is poor compared to the coupling of light propagating in the direction perpendicular to the nanowire axis. As the axis of straight nanowires normally extends in the direction normal to the substrate, coupling of light propagating in this direction is inefficient. Therefore, bending the nanowire away from the substrate normal increases the coupling of light into and out of the nanowire for light propagating in the normal direction. Additionally, as light is preferentially emitted with polarization along the NW axis, the choice of bending direction can be used to select or enhance one polarization.

According to a first preferred embodiment of the invention, the bending region is predominantly (i. e. for a main portion or completely) arranged on the upper curvature side of the at least one nanowire, in particular on the outer side of the core region. Advantageously, the deposition of the bending region is facilitated with this embodiment.

If the bending region being arranged on the upper curvature side of the at least one nanowire has a smaller band gap than the core region, the active region can be provided by the bending region itself. Advantageously, this simplifies the structure of the nanowire device. Furthermore, the light emission properties can be designed by selecting the material of the bending region.

Alternatively, if the active region has a smaller band gap than the core region and the bending region, the active region is provided additionally to the core region and the bending region. Advantageously, this provides additional degrees of freedom for designing light emission properties by selecting the semiconductor material(s) of the active region.

As a further advantage, multiple variants exist for positioning the active region, which preferably can be located in a tensely strained portion of the core region and/or between the core and bending regions and/or in a tensely strained bending portion of the bending region and/or on a surface of the bending region.

According to a second preferred embodiment of the invention, the bending region is predominantly (i. e. for a main portion or completely) arranged on an inner curvature side of the at least one nanowire, wherein the active region is located in a tensely strained portion of the core region and/or on a surface of the core region, and/or it is predominantly arranged on an upper curvature side of the at least one nanowire between the core and bending regions, in a portion of the bending region and/or on a surface of the bending region. Advantageously, the design of the bending effect of the bending region, e. g. based on different thermal expansion coefficients of the core and bending region materials, has further degrees of freedom with this embodiment. If the bending region is on the inner curvature side, it provides compressive strain for the nanowire core. It is possible that the outer curvature side is in that case also under compressive strain, but the invention concept still works because this region is tensely strained compared to the average strain in the nanowire.

According to a further preferred variant of the invention, a passivation region (or: passivation layer) can be provided for suppressing a non-radiative recombination of carriers at surfaces and/or interfaces. Advantageously, this allows an improvement of the light emission efficiency. Furthermore, multiple options for providing the passivation region are available. If the bending region is arranged on the upper curvature side of the at least one nanowire, the passivation region can be provided by the bending region. Advantageously, this simplifies the structure of the nanowire device. Alternatively, the passivation region can be provided by an additional passivation region material located in contact with the active region, in particular between the active region and the bending region. As an example, a thin (AI,Ga)As layer can be provided as the passivation region on top of a quantum dot or quantum wire. Advantageously, this provides additional degrees of freedom for designing light emission properties by selecting the material(s) of the passivation region.

As a further advantage of the invention, multiple variants for providing the active region exist, which preferably comprises at least one quantum dot, at least one quantum wire, at least one quantum well, at least one thick layer, at least one radiative point defect, like e.g. at least one implanted color center, and/or at least one extended defect. The active region may include a combination of these variants, like e.g. at least one quantum dot embedded in a quantum well.

According to a further preferred variant of the invention, the at least one nanowire includes at least one doped region. The at least one doped region may be provided by at least one of the core or bending regions or by an additional layer of the nanowire. Advantageously, the at least one doped region can be used for local doping of the nanowire, thus providing local carrier injection into the tensely strained nanowire material.

As another advantage of the invention, the bending effect of the bending region can be adjusted by setting the geometric extension thereof. According to a first variant, the bending region can extend along only a section of the length of the at least one nanowire. The bending region can be restricted to a proximal end of the nanowire (adjacent to the substrate), a middle portion of the nanowire or a distal end of the nanowire. According to a second variant, the bending region can extend along the whole length of the at least one nanowire. Additionally or alternatively, the active region can extend along a section of the length of the at least one nanowire only, preferably along the extension of the bending region or with a location farther away from substrate than the bending region.

According to a further preferred embodiment of the invention, the core region is made of GaAs and the bending region is made of (Al,In,Ga)As, or the core region is made of GaN and the bending region is made of (Al,In,Ga)N. The GaAs and GaN based embodiments are useful for an emission in the infrared spectral range, and the ultraviolet as well as visible spectral range, resp.. With these material combinations, advantages for the carrier collection effect of the bent nanowire are obtained. As a further advantage, the composition of these alloys can be chosen such that a favorable bending geometry is produced. Furthermore, the bandgap of the bending material can be chosen to be above or below that of the core (a lower bandgap is favorable when the bending region is the active region, and a higher bandgap is favorable when a separate active region is to be included).

Preferably, an average bending radius of the at least one nanowire is less than or equal to twice the unbent length of the at least one nanowire. Advantageously, this facilitates the light emission orthogonal to the substrate plane.

The nanowire device may include only one single bent nanowire. This embodiment has advantages for adapting the nanowire device for single-photon emission. Alternatively, according to a further preferred embodiment of the invention, a plurality of nanowires stand on the substrate. With typical examples, at least 100 nanowires, preferably at least 1000 nanowires are provided. Advantageously, the provision of multiple nanowires allows an increase of the light emission power of the nanowire device. According to a first variant, all nanowires can have the same bending direction. As an advantage, this embodiment provides an emission with a polarization determined by the bending direction of the nanowires. According to another variant, different bending directions can be provided, e. g. an equal distribution of bending directions can be provided. This would still be advantageous for light outcoupling and enhanced charge transport towards the active region, and would be the desirable configuration for unpolarized light emission.

Preferably, the at least one nanowire has a characteristic cross-sectional dimension, e. g. diameter, in the sub-micrometer range, i. e. below 1 µm. Generally, for producing the at least one nanowire on a substrate, "top-down" methods such as, for example, selective etching of planar semiconductors or "bottom-up" methods, such as the epitaxial growth of nanostructured semiconductors, can be used.

If the bending and core regions are crystalline materials and have different lattice constants, the at least one nanowire is bent by the effect of the different lattice constants, e. g. during the deposition of the bending region on the core region. The growth of one or several lattice mismatched bending regions, asymmetric, incomplete and/or with an asymmetric composition, around the axis of the nanowire produces an asymmetric strain profile on the nanowire structure and leads to a bending of the nanowire.

Alternatively or additionally, if the bending region has a thermal expansion coefficient different from a core region thermal expansion coefficient, the at least one nanowire is bent by the effect of the different thermal expansion coefficients during a temperature change after the deposition of the bending region on the core region.

Further details and advantages of the invention are described in the following with reference to the attached drawings, which show in:
- Figures 1 and 2:: schematic illustrations of nanowire devices according to the first embodiment of the invention, wherein the bending region is arranged on the upper curvature side of the nanowire;
- Figures 3 and 4:: schematic illustrations of nanowire devices according to the second embodiment of the invention, wherein the bending region is arranged on the lower curvature side of the nanowire;
- Figure 5: a scanning electron micrograph of a bent nanowire according to an embodiment of the invention;
- Figure 6: a diagram of the calculated axial strain in the nanowire from Figure 1;
- Figure 7: photoluminescence spectra measured with bent nanowires according to an embodiment of the invention and comparative examples; and
- Figure 8: a polar representation of the photoluminescence intensity of bent nanowires according to an embodiment of the invention and comparative examples.

Embodiments of the invention are described in the following with reference to the arrangement of in particular the core, bending and active regions of a nanowire in embodiments of an inventive nanowire device. The described features can be provided in a single nanowire device or in a multiple nanowire device. The implementation of the invention is not restricted to the described embodiments and examples. In particular, while the Figures show quantum dots as the active region only, other types of active region can be provided as mentioned above. For the practical application as a light emitter, the nanowire device is provided with further components, like electrical contacts on a substrate for injecting an excitation current into the nanowire and optionally an encapsulation layer embedding the nanowire(s) and carrying an electrical contact. The nanowire device is manufactured e. g. by an epitaxial growth of the nanowire regions on the substrate, wherein the nanowire is bent by the effect of lattice mismatch and/or different thermal expansion coefficients.

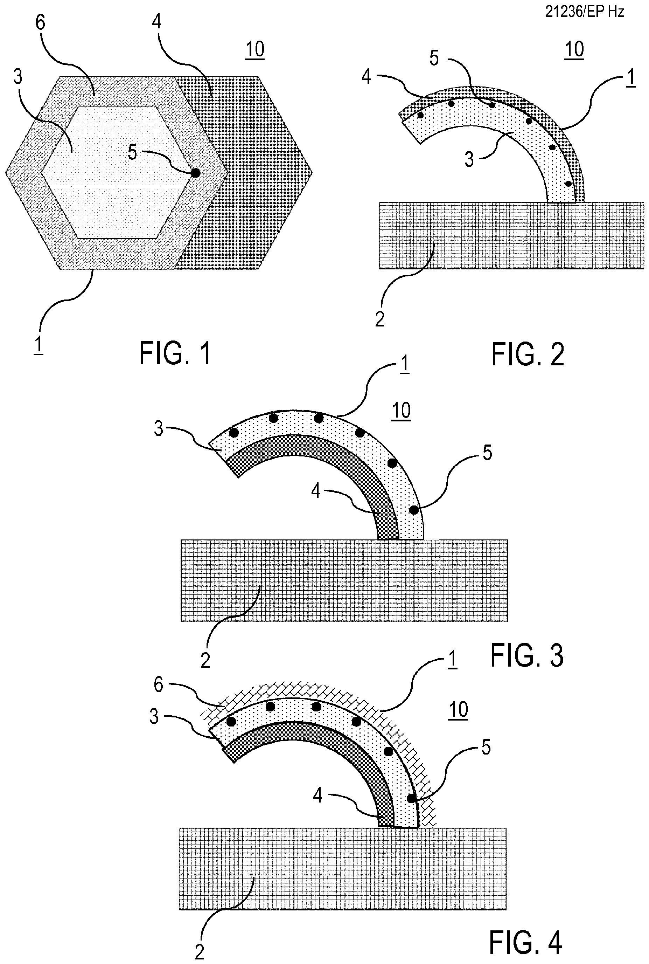

Figure 1 shows a cross-sectional view of an exemplary nanowire device 10, composed of a bent nanowire 1 standing on a substrate (not shown, see e.g. Figure 2). According to the illustrated first embodiment of the invention, a bending region 4 is arranged on an upper curvature side of the nanowire 1.

The nanowire 1 has a core region 3 (diameter e. g. about 100 nm, material e. g. GaAs, possibly doped with Si, C, or Be) grown on the substrate, an active region 5 (material e. g. (In,Ga)As) with a bandgap lower than the core region 3, a passivation region 6 (thickness e. g. about 10 nm, material e. g. (Al, Ga)As with 30% Al, possibly doped with Si, C, or Be) having a bandgap larger than that of the core region 3, and the bending region 4 (thickness e. g. about 40 nm, material e. g. Al_{0.5}In_{0.5}As, possibly doped with Si, C, or Be). The nanowire 1 has a hexagonal cross section, however the cross section is not restricted to the hexagonal case. As an alternative example, a cylindrical shape of the core region 3 can be provided. The nanowire 1 length and bending radius are e. g. about 4 µm and about 3 µm, respectively.

The active region 5 comprises quantum dots, which are arranged at the interface between the core and passivation regions 3, 6. With the above examples, the lattice constant difference of the core region 3 and the bending region 4 is about 3.6 %, resulting in an axial strain in the nanowire. The value of the axial strain in the bent nanowire 1 increases from the inside toward the outer part of the bending arc.

The nanowire device 10 of Figure 1 is operated as a light emitting device by injecting an electrical excitation current from a power source (not shown) via electrical contacts (not shown) into the nanowire 1. The charge carriers are collected in the active region 5 where light emission is generated as a result of carrier recombination.

The provision of the passivation region 6 is an optional feature of the inventive nanowire device 10. The passivation region 6 can be omitted as shown in Figure 2, which shows a side view of another exemplary nanowire device 10 according to the first embodiment of the invention, wherein the bending region 4 is arranged on an upper curvature side of the nanowire 1. With this example, the active region 5 is arranged at the interface of the core region 3 and bending region 4. The regions 3 to 5 can be provided as mentioned with reference to Figure 1. The nanowire is bent relative to the normal of the substrate. The substrate 2 is e. g. a doped Si(111) wafer, including an electrical contact (not shown).

Figures 3 and 4 schematically show side views of the nanowire device 10 according to the second embodiment of the invention, wherein the bending region 4 is arranged on a lower curvature side of the nanowire 1, in contact with the core region 3. The active region 5 is arranged on a surface of the core region 3. The bending region 4 (thickness e. g. 50 nm, material e. g. Al) has a different thermal expansion coefficient compared with the core region 3. If the nanowire is deposited at an increased substrate temperature, e. g. 500 to 650 °C, the nanowire 1 is bent during cooling thereof e. g. to room temperature. The regions 3 and 5 can be provided as mentioned with reference to Figure 1. According to Figure 4, additionally a passivation region 6 is provided, and the active region 5 is arranged at the interface between the core and passivation regions 3, 6. As an alternative to Figure 4, the passivation region could be deposited in such a way that it surrounds the entire core region, i.e. before deposition of the bending region.

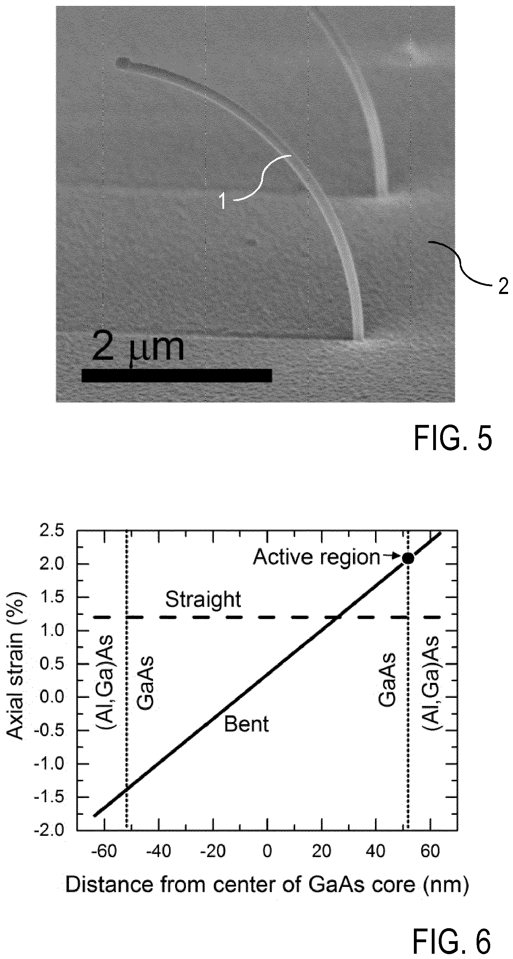

Figure 5 shows a scanning electron micrograph of a bent nanowire 1 deposited on a Si(111) substrate 2 and with the structure outlined in Figure 1, where GaAs, (In,Ga)As, (AI,Ga)As, and (Al,In,Ga)As are used as core region 3, active region 5, shell region 6 and bending region 4, respectively. This and similar structures are of interest for the realization of light-emitting devices operating in the telecommunication wavelength range (1.3 to 1.55 µm).

In Figure 6, the axial strain throughout the GaAs nanowire core region 3 and the (AI,Ga)As shell region 6 is plotted for both the bent nanowire 1 of Figure 1 and for the comparative conventional case of a straight nanowire, where the bending material was deposited as a uniform coherent shell (producing a straight nanowire with a uniform tensely strained core). The axial strain in the GaAs core region 3 increases from -1.4 % to 2.1 % from the inside to the outside of the bending arc. Using the deformation potentials reported for GaAs, this variation in strain state across the nanowire's section corresponds to a bandgap change of nearly 300 meV. As a result, carriers drift towards the outside region of the GaAs core region 3, where the (In,Ga)As quantum dot active region 5 is located. In addition to an enhanced carrier capture cross section, the quantum dot active region exhibits a redshifted emission wavelength as the tensile strain at the outer side of the GaAs core region 5 is larger than for the unbent case.

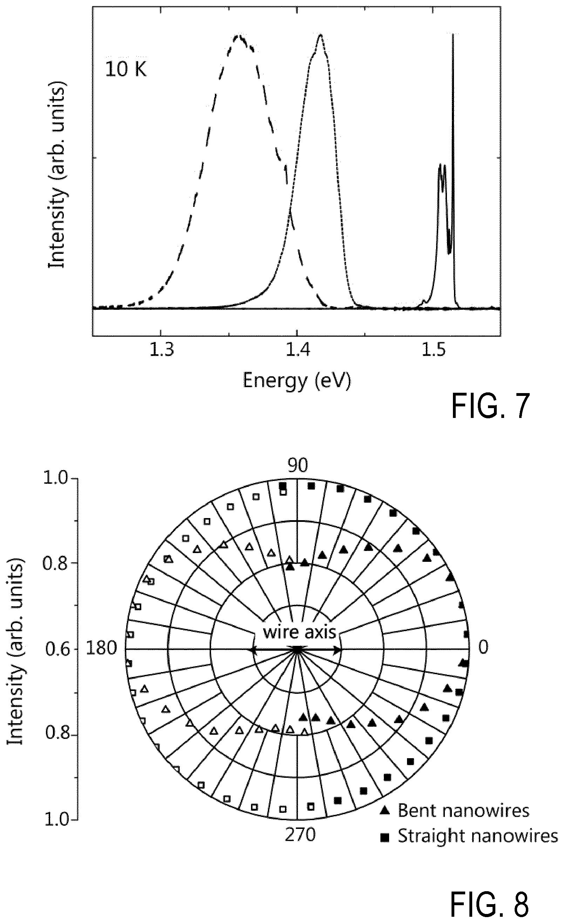

Figure 7 shows normalized photoluminescence spectra at 10 K taken on a GaAs epilayer (solid line) as well as on ensembles of straight and bent GaAs/(Al,Ga)As/(Al,In)As nanowires deposited on a Si(111) substrate (dotted and dashed lines, respectively). The bent GaAs/(Al,Ga)As/(Al,In)As nanowires have the structure of Figure 1 (without the active region 5), i. e. GaAs is a core region, (AI,Ga)As is a passivation region, and (Al,In)As is a bending region. For all these samples, the photoluminescence at 10 K is dominated by charge carrier recombination in GaAs. The photoluminescence peak energy for the bent nanowire is lower than that of the straight ones, highlighting that (i) the strain field leads to drift of carriers towards the more tensely strained region of the nanowires, and (ii) the tensile strain at the outer side of the GaAs core is larger in the case of the bent nanowires than for the unbent ones.

Figure 8 shows the dependence on the polarization of the excitation laser of the photoluminescence intensity from ensembles of straight (squares) and bent (triangles) nanowires at 10 K measured in backscattering geometry (filled symbols). The polarization of the photoluminescence signal is shown in the same figure (open symbols). While the polarization response of conventional straight nanowires is isotropic, inventive bent nanowires exhibit enhanced light absorption and emission for light polarized along the nanowire axis. This result is a consequence of the antenna effect and it demonstrates the increased light coupling efficiency of bent nanowires compared to straight ones.

The scope of the invention is solely defined by the appended claims.

## Claims

1. Nanowire device (10) for optical or optoelectronic applications, comprising
- at least one nanowire (1) standing on a substrate (2), wherein the at least one nanowire (1) includes a core region (3) and a bending region (4) being adapted for inducing strain in the at least one nanowire (1) such that the at least one nanowire (1) is bent in a bending direction deviating from the normal direction of the substrate (2), wherein
- the core region (3) and an active region (5) provide a heterostructure being configured for light emission by carrier recombination,
**characterized in that**
- the at least one nanowire (1) includes the active region (5) being located in a tensely strained portion of the at least one nanowire (1), wherein the tensely strained portion has a tensile strain compared to an average strain in the at least one nanowire (1).

2. Nanowire device according to claim 1, wherein
- the bending region (4) is predominantly arranged on an upper curvature side of the at least one nanowire (1).

3. Nanowire device according to claim 2, wherein
- the bending region (4) has a smaller band gap than the core region (3), and
- the active region is provided by the bending region.

4. Nanowire device according to claim 2, wherein
- the active region (5) has a smaller band gap than the core region (3) and the bending region (4), and
- the active region (5) is provided additionally to the core region (3) and the bending region (4).

5. Nanowire device according to claim 4, wherein
- the active region (5) is located in a tensely strained portion of the core region (3), between the core and bending regions (3, 4), in a portion of the bending region (4) and/or on a surface of the bending region (4).

6. Nanowire device according to claim 1, wherein
- the bending region (4) is predominantly arranged on an inner curvature side of the at least one nanowire (1), wherein
- the active region (5) is located in a tensely strained portion of the core region (3) and/or on a surface of the core region (3), and/or is predominantly arranged on an upper curvature side of the at least one nanowire (1) between the core and bending regions (3, 4), in a portion of the bending region (4) and/or on a surface of the bending region (4).

7. Nanowire device according to one of the foregoing claims, further comprising
- a passivation region (6) being arranged for suppressing a non-radiative recombination of carriers at surfaces and/or interfaces .

8. Nanowire device according to claim 7, wherein
- the bending region (4) is predominantly arranged on an upper curvature side of the at least one nanowire (1) and the passivation region (6) is provided by the bending region (4), or
- the passivation region (6) is provided by an additional passivation region (6) material located in contact with the active region (5).

9. Nanowire device according to one of the foregoing claims, including at least one of the features
- the active region (5) comprises at least one quantum dot, at least one quantum wire, at least one quantum well, at least one thick layer, at least one radiative point defect and/or at least one extended defect, and
- the at least one nanowire (1) includes at least one doped region.

10. Nanowire device according to one of the foregoing claims, including at least one of the features
- the bending region (4) extends along a section of the length of the at least one nanowire (1), and
- the active region (5) extends along a section of the length of the at least one nanowire (1).

11. Nanowire device according to one of the foregoing claims, wherein
- the core region (3) is made of GaAs and the bending region (4) is made of (Al,In,Ga)As, or
- the core region (3) is made of GaN and the bending region (4) is made of (Al,In,Ga)N.

12. Nanowire device according to one of the foregoing claims, wherein
- an average bending radius of the at least one nanowire (1) is less than or equal to twice the unbent length of the at least one nanowire (1).

13. Nanowire device according to one of the foregoing claims, wherein
- a plurality of nanowires (1) stand on the substrate (2), wherein
- all nanowires (1) have the same bending direction or different bending directions.

14. Method of manufacturing the nanowire device (10) according to one of the foregoing claims, comprising the steps of
- creating the at least one nanowire (1) on the substrate (2), and
- depositing the bending region (4), so that the at least one nanowire (1) is bent in the bending direction.

15. Method according to claim 14, wherein
- the bending region (4) has a lattice constant different from the core region lattice constant and the at least one nanowire (1) is bent by the effect of the different lattice constants.

16. Method according to claim 14 or 15, wherein
- the bending region (4) has a thermal expansion coefficient different from the core region thermal expansion coefficient and the at least one nanowire (1) is bent by the effect of the different thermal expansion coefficients.

## Patentansprüche

1. Nanodrahtvorrichtung (10) für optische oder optoelektronische Anwendungen, umfassend
- mindestens einen Nanodraht (1), der auf einem Substrat (2) steht, wobei der mindestens eine Nanodraht (1) einen Kernbereich (3) und einen Biegebereich (4) enthält, der angepasst ist, eine Spannung in dem mindestens einen Nanodraht (1) zu induzieren, so dass der mindestens eine Nanodraht (1) in einer Biegerichtung gebogen wird, die von der Normalrichtung des Substrats (2) abweicht, wobei
- der Kernbereich (3) und ein aktiver Bereich (5) eine Heterostruktur bereitstellen, die für eine Lichtemission durch Trägerrekombination konfiguriert ist,
**dadurch gekennzeichnet, dass**
- der mindestens eine Nanodraht (1) den aktiven Bereich (5) enthält, der in einem zugverspannten Abschnitt des mindestens einen Nanodrahtes (1) angeordnet ist, wobei der zugverspannte Abschnitt eine Dehnungsspannung im Vergleich zu einer durchschnittlichen Spannung in dem mindestens einen Nanodraht (1) aufweist.

2. Nanodrahtvorrichtung gemäß Anspruch 1, wobei
- der Biegebereich (4) überwiegend auf einer oberen Krümmungsseite des mindestens einen Nanodrahtes (1) angeordnet ist.

3. Nanodrahtvorrichtung gemäß Anspruch 2, wobei
- der Biegebereich (4) eine kleinere Bandlücke als der Kernbereich (3) aufweist, und
- der aktive Bereich wird durch den Biegebereich bereitgestellt wird.

4. Nanodrahtvorrichtung gemäß Anspruch 2, wobei
- der aktive Bereich (5) eine kleinere Bandlücke aufweist als der Kernbereich (3) und der Biegebereich (4), und
- der aktive Bereich (5) zusätzlich zum Kernbereich (3) und zum Biegebereich (4) vorgesehen ist.

5. Nanodrahtvorrichtung gemäß Anspruch 4, wobei
- der aktive Bereich (5) in einem zugverspannten Abschnitt des Kernbereichs (3), zwischen den Kern- und Biegebereichen (3, 4), in einem Abschnitt des Biegebereichs (4) und/oder auf einer Oberfläche des Biegebereichs (4) angeordnet ist.

6. Nanodrahtvorrichtung gemäß Anspruch 1, wobei
- der Biegebereich (4) überwiegend auf einer inneren Krümmungsseite des mindestens einen Nanodrahtes (1) angeordnet ist, wobei
- der aktive Bereich (5) in einem zugverspannten Abschnitt des Kernbereichs (3) und/oder auf einer Oberfläche des Kernbereichs (3) angeordnet ist und/oder überwiegend auf einer oberen Krümmungsseite des mindestens einen Nanodrahtes (1) zwischen den Kern- und Biegebereichen (3, 4), in einem Abschnitt des Biegebereichs (4) und/oder auf einer Oberfläche des Biegebereichs (4), angeordnet ist.

7. Nanodrahtvorrichtung gemäß einem der vorhergehenden Ansprüche, ferner umfassend
- einen Passivierungsbereich (6), der zum Unterdrücken einer nichtstrahlenden Rekombination von Trägern an Oberflächen und/oder Grenzflächen angeordnet ist.

8. Nanodrahtvorrichtung gemäß Anspruch 7, wobei
- der Biegebereich (4) überwiegend auf einer oberen Krümmungsseite des mindestens einen Nanodrahtes (1) angeordnet ist und der Passivierungsbereich (6) durch den Biegebereich (4) bereitgestellt wird, oder
- der Passivierungsbereich (6) durch ein zusätzliches Passivierungsbereich-(6)-Material bereitgestellt wird, das in Kontakt mit dem aktiven Bereich (5) angeordnet ist.

9. Nanodrahtvorrichtung gemäß einem der vorhergehenden Ansprüche, die mindestens eines der Merkmale enthält
- der aktive Bereich (5) umfasst mindestens einen Quantenpunkt, mindestens einen Quantendraht, mindestens ein Quantenwell, mindestens eine Dickschicht, mindestens einen strahlenden Punktfehler und/oder mindestens eine erweiterte Fehlstelle, und
- der mindestens eine Nanodraht (1) enthält mindestens einen dotierten Bereich.

10. Nanodrahtvorrichtung gemäß einem der vorhergehenden Ansprüche, die mindestens eines der Merkmale enthält
- der Biegebereich (4) erstreckt sich entlang eines Abschnitts der Länge des mindestens einen Nanodrahtes (1), und
- der aktive Bereich (5) erstreckt sich entlang eines Abschnitts der Länge des mindestens einen Nanodrahtes (1).

11. Nanodrahtvorrichtung gemäß einem der vorhergehenden Ansprüche, wobei
- der Kernbereich (3) aus GaAs und der Biegebereich (4) aus (Al,In,Ga)As hergestellt ist, oder
- der Kernbereich (3) aus GaN und der Biegebereich (4) aus (Al,In,Ga)N hergestellt ist.

12. Nanodrahtvorrichtung gemäß einem der vorhergehenden Ansprüche, wobei
- ein durchschnittlicher Biegeradius des mindestens einen Nanodrahtes (1) kleiner oder gleich dem Doppelten der ungekrümmten Länge des mindestens einen Nanodrahtes (1) ist.

13. Nanodrahtvorrichtung gemäß einem der vorhergehenden Ansprüche, wobei
- eine Vielzahl von Nanodrähten (1) auf dem Substrat (2) stehen, wobei
- alle Nanodrähte (1) die gleiche Biegerichtung oder unterschiedliche Biegerichtungen aufweisen.

14. Verfahren zur Herstellung der Nanodrahtvorrichtung (10) gemäß einem der vorhergehenden Ansprüche, umfassend die Schritte
- Erzeugen des mindestens einen Nanodrahtes (1) auf dem Substrat (2), und
- Abscheiden des Biegebereichs (4), so dass der mindestens eine Nanodraht (1) in Biegerichtung gebogen wird.

15. Verfahren gemäß Anspruch 14, wobei
- der Biegebereich (4) eine von der Gitterkonstante des Kernbereichs verschiedene Gitterkonstante aufweist und der mindestens eine Nanodraht (1) durch die Wirkung der verschiedenen Gitterkonstanten gebogen wird.

16. Verfahren gemäß Anspruch 14 oder 15, wobei
- der Biegebereich (4) einen vom Kernbereich verschiedenen Wärmeausdehnungskoeffizienten aufweist und der mindestens eine Nanodraht (1) durch die Wirkung der unterschiedlichen Wärmeausdehnungskoeffizienten gebogen wird.

## Revendications

1. Dispositif de nanofil (10) pour applications optiques ou optoélectroniques, comprenant
- au moins un nanofil (1) posé sur un substrat (2), dans lequel l'au moins un nanofil (1) inclut une région d'âme (3) et une région de flexion (4) étant adaptée pour induire une déformation dans l'au moins un nanofil (1) de telle manière que l'au moins un nanofil (1) est fléchi dans une direction de flexion s'écartant de la direction normale du substrat (2), dans lequel
- la région d'âme (3) et une région active (5) fournissent une hétérostructure étant configurée pour une émission de lumière par recombinaison de porteurs,
**caractérisé en ce que**
- l'au moins un nanofil (1) inclut la région active (5) étant située dans une partie déformée par traction de l'au moins un nanofil (1), dans lequel la partie déformée par traction présente une déformation par traction comparativement à une déformation moyenne dans l'au moins un nanofil (1).

2. Dispositif de nanofil selon la revendication 1, dans lequel
- la région de flexion (4) est principalement agencée sur un côté de courbure supérieur de l'au moins un nanofil (1).

3. Dispositif de nanofil selon la revendication 2, dans lequel
- la région de flexion (4) a une bande interdite plus petite que la région d'âme (3), et
- la région active est fournie par la région de flexion.

4. Dispositif de nanofil selon la revendication 2, dans lequel
- la région active (5) a une bande interdite plus petite que la région d'âme (3) et la région de flexion (4), et
- la région active (5) est en outre fournie à la région d'âme (3) et à la région de flexion (4).

5. Dispositif de nanofil selon la revendication 4, dans lequel
- la région active (5) est située dans une partie déformée par traction de la région d'âme (3), entre les régions d'âme et de flexion (3, 4), dans une partie de la région de flexion (4) et/ou sur une surface de la région de flexion (4).

6. Dispositif de nanofil selon la revendication 1, dans lequel
- la région de flexion (4) est principalement agencée sur un côté de courbure interne de l'au moins un nanofil (1), dans lequel
- la région active (5) est située dans une partie déformée par traction de la région d'âme (3) et/ou sur une surface de la région d'âme (3), et/ou est principalement agencée sur un côté de courbure supérieur de l'au moins un nanofil (1) entre les régions d'âme et de flexion (3, 4), dans une partie de la région de flexion (4) et/ou sur une surface de la région de flexion (4).

7. Dispositif de nanofil selon l'une des revendications précédentes, comprenant en outre
- une région de passivation (6) étant agencée pour supprimer une recombinaison non radiative de porteurs au niveau de surfaces et/ou d'interfaces.

8. Dispositif de nanofil selon la revendication 7, dans lequel
- la région de flexion (4) est principalement agencée sur un côté de courbure supérieur de l'au moins un nanofil (1) et la région de passivation (6) est fournie par la région de flexion (4), ou
- la région de passivation (6) est fournie par un matériau de région de passivation supplémentaire (6) situé en contact avec la région active (5).

9. Dispositif de nanofil selon l'une des revendications précédentes, incluant au moins l'une des caractéristiques
- la région active (5) comprend au moins un point quantique, au moins un fil quantique, au moins un puits quantique, au moins une couche épaisse, au moins un défaut ponctuel radiatif et/ou au moins un défaut étendu, et
- l'au moins un nanofil (1) inclut au moins une région dopée.

10. Dispositif de nanofil selon l'une des revendications précédentes, incluant au moins l'une des caractéristiques
- la région de flexion (4) s'étend le long d'une section de la longueur de l'au moins un nanofil (1), et
- la région active (5) s'étend le long d'une section de la longueur de l'au moins un nanofil (1).

11. Dispositif de nanofil selon l'une des revendications précédentes, dans lequel
- la région d'âme (3) est faite de GaAs et la région de flexion (4) est faite de (Al,In,Ga)As, ou
- la région d'âme (3) est faite de GaN et la région de flexion (4) est faite de (Al,In,Ga)N.

12. Dispositif de nanofil selon l'une des revendications précédentes, dans lequel
- un rayon de flexion moyen de l'au moins un nanofil (1) est inférieur ou égal à deux fois la longueur non fléchie de l'au moins un nanofil (1).

13. Dispositif de nanofil selon l'une des revendications précédentes, dans lequel
- une pluralité de nanofils (1) est posée sur le substrat (2), dans lequel
- tous les nanofils (1) ont la même direction de flexion ou différentes directions de flexion.

14. Procédé de fabrication du dispositif de nanofil (10) selon l'une des revendications précédentes, comprenant les étapes de
- création de l'au moins un nanofil (1) sur le substrat (2), et
- dépôt de la région de flexion (4), de sorte que l'au moins un nanofil (1) est fléchi dans la direction de flexion.

15. Procédé selon la revendication 14, dans lequel
- la région de flexion (4) a une constante de réseau différente de la constante de réseau de la région d'âme et l'au moins un nanofil (1) est fléchi par l'effet des différentes constantes de réseau.

16. Procédé selon la revendication 14 ou 15, dans lequel
- la région de flexion (4) a un coefficient de dilatation thermique différent du coefficient de dilatation thermique de la région d'âme et l'au moins un nanofil (1) est fléchi par l'effet des différents coefficients de dilatation thermique.
